# EUROPEAN PATENT APPLICATION

(11) **EP 4 783 167 A2**
(43) Date of publication of application: **29.07.2026**
(21) Application number: 25215659.1
(22) Date of filing: 13.11.2025
(51) Int. Cl.: G11C 5/04

(54) **SELF-ALIGNED PICK AND PLACE METHODS AND APPARATUSES**

(30) Priority: 27.12.2024 US 202419003302
(71) Applicant: Intel Corporation, Santa Clara, CA 95054 (US)
(72) Inventor: SHI, Yi, Chandler, AZ 85248 (US); EID, Feras, Chandler, AZ 85226 (US); BRUN, Xavier, Chandler, AZ 85224 (US); EL HELOU, Charles, Scottsdale, AZ 85251 (US)
(74) Representative: HGF

(57) **Abstract**

In some embodiments, pick and place tools can pick and place multiple dies with different die sizes from different source wafers at a time to increase the throughput. In addition, some of these tools may incorporate non-contact die handling during pick and place processes. In some examples, the non-contact mechanisms can use Bernoulli effects or acoustic wave or vibration techniques to hold and release dies.

## Description

### TECHNICAL FIELD

Embodiments relate to the field of semiconductor assembly apparatuses; and more specifically, to die to wafer pick and place apparatuses.

### BRIEF DESCRIPTION OF THE DRAWINGS

The disclosure may best be understood by referring to the following description and accompanying drawings that are used to illustrate embodiments of the invention. In the drawings:
FIG. 1 shows an example die-to-wafer self-aligning and bonding process.
FIG. 2 shows an example die-to-wafer bonding process that involves the reconstitution of the source wafer of FIG. 1.
FIG. 3 shows example die arrangements for placement on a wafer.
FIG. 4 shows an example pick-and-place assembly for picking up the example die arrangements of FIG. 3.
FIG. 5A shows the example pick-and-place assembly of FIG. 4 picking up the dies of FIG. 3.
FIG. 5B illustrates a pick-and-place assembly implementing means for positioning a plurality of dies on the water droplets on a semiconductor wafer.
FIG. 6 shows an example wafer including the dies of FIG. 3.
FIG. 7 shows the example wafer of FIG. 6 before and after the application of water to facilitate the self-alignment of the example dies of FIG. 2 on the example wafer of FIG. 6.
FIG. 8A illustrates how a die may be transferred using a non-contact nozzle in accordance with some embodiments.
FIG. 8B is a diagram illustrating how batch pick and place can be implemented with non contact nozzles in accordance with some embodiments.
FIGS. 9A-9C are diagrams contrasting contact and non-contact nozzles and providing examples of non contact nozzles in accordance with some embodiments.
FIG. 10 shows an example fluid dispensing assembly to dispense water on the example wafer of FIG. 6.
FIGS. 11-13 show a first example bonding machine for dispensing fluid and picking and placing the dies of FIG. 3.
FIG. 14 is a flowchart representative of example methods to implement the example die-to-wafer self-aligning and bonding process of FIGS. 1 and/or 2.
FIG. 15 is a block diagram of an example processing platform including programmable circuitry structured to execute, instantiate, and/or perform the example machine readable instructions and/or perform the example operations of FIGS. 17-19 to implement the example die-to-wafer self-aligning and bonding process 100 of FIG. 1.

### DETAILED DESCRIPTION

In die to wafer (D2W) hybrid bonding, achieving ~ 200 nm alignment accuracy or even lower is desired for electrical performance as the bump pitch is scaled down. Achieving this accuracy at a high enough throughput is challenging with current hybrid bonding equipment, since the throughput is dominated by the time required to perform active alignment at this scale. One way to address this challenge is by using self-assembly, in which the wafers and dies are patterned to create hydrophobic regions around the hydrophilic bonding areas. Water droplets are then dispensed in the bonding regions on the wafer and are confined by the surrounding hydrophobic areas. The top dies are then placed with high throughput, coarse alignment equipment (with misalignment on the order of few microns or more). The capillary action from the liquid will then passively align the dies to the wafer locations with final alignment that can be on the order of 200 nm or better, as defined lithographically during the patterning of the hydrophobic regions. This approach enables the best of both worlds, i.e. using high throughput equipment and still achieving the fine final alignment required for hybrid bonding.

To leverage the strength of self-assembly, it is also desired to pick and place multiple dies simultaneously and letting the capillary action drive each into fine alignment. Since initial coarse alignment is now permissible, the initial arrangement of the dies, and their alignments with respect to each other, no longer need to match the final, strict alignment after bonding, which is realized by self-assembly. To enable this capability, equipment that can pick and place multiple dies is desired.

Self-assembly based die-to-wafer (D2W) hybrid bonding works ideally with zero release force (ZRF) at final die placement to ensure best D2W alignment results driven by fluidic self-assembly mechanisms. While the capillary force from the droplets can be used to both release the dies (in the case of non-zero release force from the bond head) and produce final alignment, decoupling of the two requirements (i.e. facilitating the zero force that are desired during release, and using the capillary force for alignment) can provide additional flexibility and lead to better optimization of the dispense conditions for minimizing final die-to-wafer placement errors.

Unfortunately, conventional batch pick and place solutions use nozzles that contact the dies to be placed and released. These nozzle types include vacuum based nozzles, adhesion-based gang bonding nozzles, and laser lift-off nozzles. With these approaches, it can be challenging to achieve sufficient zero release force (ZRF) of the dies. Accordingly, new approaches are desired.

In some embodiments, pick and place tools can pick and place multiple dies with different die sizes from different source wafers at a time to increase the throughput. In addition, some of these tools may incorporate non-contact die handling during pick and place processes. For example, in some examples, the non-contact mechanisms can use Bernoulli effects or acoustic wave or vibration techniques to hold and release dies.

With such nozzle types, non contact dies can be released by their own gravity, e.g., not using blow-off or other mechanisms that can create additional downward or upward forces during release. Not only can release be performed more reliably, but also, non-contact tooling in general also promotes cleanliness, not directly contacting the dies so that little, if any, tooling cleaning) is needed.

To achieve sub-micron die placement accuracy at high speed (> 2,000 UPH) is difficult and process requires specific fiducial design to achieve required accuracy. Self-assembly based D2W process relaxes the requirement for die placement accuracy because the capillary action of the water will auto correct the XY and rotational error post placement. Therefore, the bonder can have significantly higher run rate (4,000-8,000 UPH) with relaxed placement accuracy requirements (5-10 uM). To further utilize the benefit of self-assembly, batch processes (multiple dies picking and placing simultaneously) can be used to drive run rate to greater than 20,000 UPH (units per hour).

Traditional batch pick and place typically utilizes vacuum based nozzle with a blow-off function to ensure residual vacuum is released and to counter the Van Der Waals force between the nozzle and the die after vacuum is turned off, and release the dies to the target wafer. During die release, blow-off will create additional down force onto the die, which is undesirable.

With some approaches, the Van Der Waals force between the nozzle and the die is countered by optimizing the capillary force created by the droplets for releasing the dies, and then achieving fine alignment. This coupling (i.e. optimizing the liquid volume for both release and alignment) can be avoided if a true zero release force bond head is available such that there is zero residual adhesion between the die and bond head during release. This allows for tuning of the liquid volume for alignment without having to worry so much about release, providing greater flexibility to tune the process conditions specifically for minimizing misalignment after self-assembly. To achieve a zero release force, in some embodiments, non-contact nozzles are used for batch pick and place. The principal mechanisms for achieving non-contact nozzles (levitation between die and nozzle surface without touching) can be achieved with any suitable approach including Bernoulli effect levitation, acoustic wave levitation, vibration with vacuum levitation, etc.

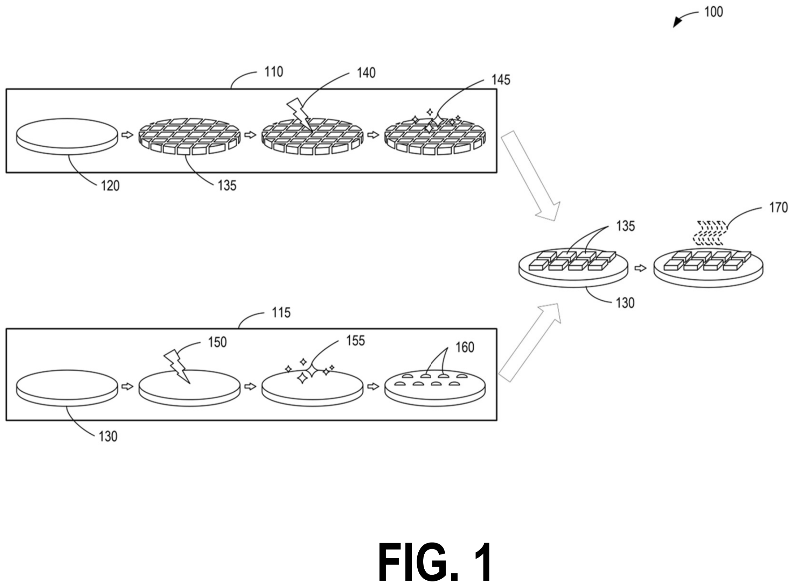

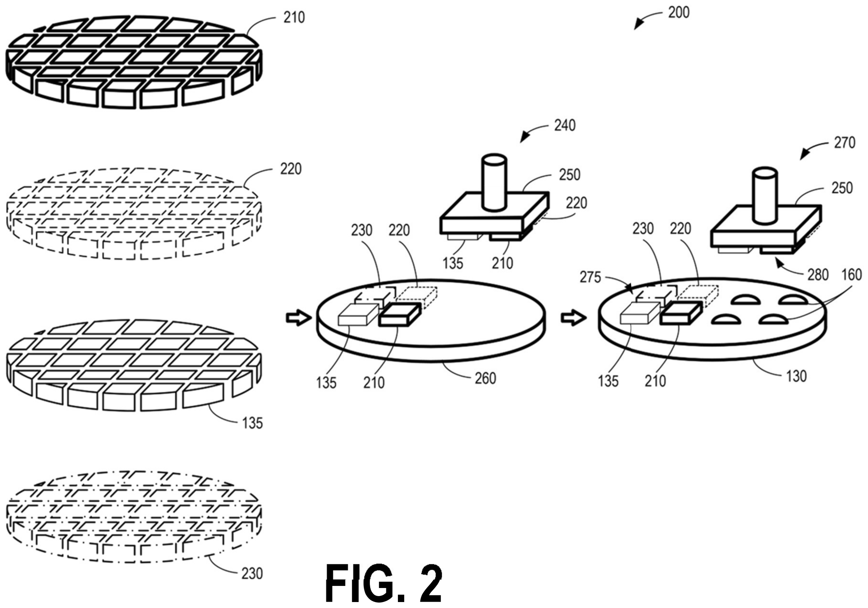

FIG. 1 shows an example die-to-wafer self-aligning and bonding process 100. The die-to-wafer self-aligning and bonding process 100 includes a first wafer 120 and a second wafer 130. In this example, the dies (e.g., semiconductor dies 135) are initially on the first wafer 120 (also referred to herein as a source wafer) and transferred and bonded to the second wafer 130 (also referred to herein as a target wafer). In the illustrated example of FIG. 1, the source wafer 120 is a semiconductor wafer on which individual semiconductor dies are fabricated using any suitable fabrication processes. In other examples, the source wafer 120 is a reconstituted wafer that contains semiconductor dies that were fabricated on one or more other wafers and then transferred to the source wafer 120. The process of reconstitution is discussed further below in connection with FIG. 2.

In the example disclosed herein, the first (source) wafer 120 goes through a first preparation process 110 and the second (target) wafer 130 goes through a second preparation process 115. The first and second preparation processes 110, 115 can be performed independent of one another. Thus, in some examples, the first and second preparation processes 110, 115 are implemented in parallel. The first preparation process 110 begins with the top surface of the first wafer 120 being smoothed, flattened, or polished by a chemical mechanical planarization (CMP) process. Having a smooth and/or flat surface facilitates the hybrid bonding to occur later in the process. Once planarized, the first wafer 120 is cut (e.g., singulated, diced) to obtain semiconductor dies 135. In some examples, the semiconductor dies 135 are cut into pre-defined shapes and orientations which are determined based on the application in which the semiconductor dies 135 are to be used (e.g., a processor, memory, an integrated circuit, etc.).

The semiconductor dies 135 of the first wafer 140 are subjected to a first plasma activation 140. In some examples, the first plasma activation 140 applies a plasma treatment (e.g., using an ionized gas, such as N2, H2 and O2, to form plasma) to the semiconductor dies 135 to change the surface chemistry of bonding points (e.g., activates or energizes the surface to increase adhesion characteristics) of the semiconductor dies 135 to increase a bonding strength between the semiconductor dies 135 and the second wafer 130.

After the semiconductor dies 135 are subjected to the first plasma activation 140, the semiconductor dies 135 are subjected to a first cleaning/hydration 145. The first cleaning 145 removes any unwanted debris from the surface of the bonding points (e.g., produced from the dicing process or otherwise) and ensures that the bonding points are properly prepared for bonding. The first cleaning 145 also serves as a hydration step to increase the amount of hydroxyl groups on the surface.

The second preparation process 115 for the second (target) wafer 130 has similarities with the first preparation process 110. For instance, the second preparation process 115 begins with the top surface of the second wafer 130 undergoing a CMP process to smooth, flatten, or polish the surface. Once planarized, the second wafer 130 is subjected to a second plasma activation 150 (e.g., similar process to that of the first plasma activation 140). In some examples, the target wafer 130 is formed to include multiple materials (e.g., silicon, germanium, etc.) to create contrasting regions on the surface of the target wafer 130. In some such examples, the target wafer 130 has contrasting regions that, when activated, become hydrophilic regions that attract fluids and hydrophobic regions that repel fluids.

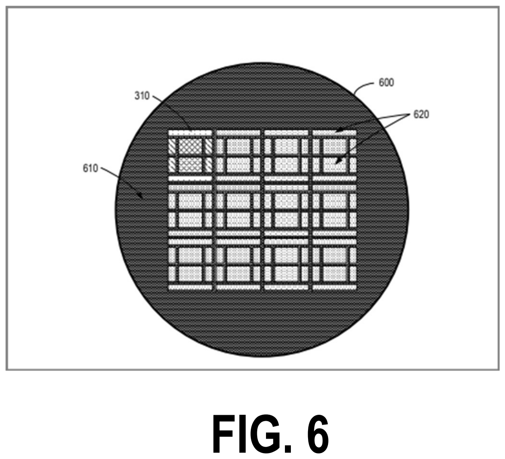

In examples disclosed herein, the second plasma activation 150 activates the surface of the second wafer 130 to activate hydrophobic regions and hydrophilic regions. The second plasma activation 150 ensures that the semiconductor dies 135, when placed on the second wafer 130, self-align to the correct regions on the second wafer 130 using the die-to-wafer hybrid bonding process disclosed herein. The hydrophobic and hydrophilic regions are discussed further herein with respect to FIG. 6.

The second wafer 130 is subjected to a second cleaning 155. The second cleaning 155 removes any unwanted debris from the surface of the second wafer 130 and ensures that the bonding points are properly prepared for bonding, similar to that of the first cleaning 145.

To perform the die-to-wafer self-aligning and bonding process 100 disclosed herein, water droplets 160 are placed on the second wafer 130, defining where the semiconductor dies 135 are to bond to the second wafer 130. In examples disclosed herein, the water droplets 160 are placed on the hydrophilic regions of the second wafer 130. Due to the hydrophilic properties of the region, the water droplets 160 will spread out in a thin film rather than bead up on the surface. However, due to the hydrophobic regions surrounding the hydrophilic regions, the water will spread up to but not over the edge of the hydrophilic regions such that the water droplets 160 remain in the desired locations (e.g., within the hydrophilic regions) on the second wafer 130. This allows the semiconductor dies 135, once placed on the water droplets 160, to self-align through capillary forces that force the semiconductor dies 135 into alignment with the hydrophilic regions. In some examples, the amount or volume of the water droplets 160 dispensed on a given hydrophilic region is controlled to be sufficient to cover the entire hydrophobic regions with a relatively thin film layer of water having a relatively controlled volume (e.g., less than 1 microliter and can be on the nanoliter scale). Thus, larger hydrophilic regions will have more water than smaller hydrophilic regions.

After the water droplets 160 have been placed on the second wafer 130, the first and second preparation processes 110, 115 are complete and the semiconductor dies 135 are then picked up and placed on the second wafer 130 at the hydrophilic regions. While the separate preparation processes 110, 115 can be done in parallel and/or at different times, the dispensing of the water droplets 160 is done close in time to when the semiconductor dies 135 are to be transferred from the first (source) wafer 130 to the second (target) wafer 130 so that water is still present when the dies 135 are placed thereon. This timeframe is relatively small because the volume of the water droplets is relatively small and, therefore, may evaporate relatively quickly. In this example, the alignment of the semiconductor dies 135 does not need to be as precise as many known pick and place processes because the thin film layer of water that is already precisely spread across the hydrophilic region will cause a slightly misaligned die 135 to move into alignment with the underlying hydrophilic region (based on water surface tension properties and/or capillary action of the water interacting with the interfacing surface of the die 135). Inasmuch as the self-aligning capabilities of the water enables the initial alignment of the dies from the pick and place process to be less precise than known approaches, the pick and place process disclosed herein can be done at a faster speed than known approaches.

The combined semiconductor dies 135 and second wafer 130 are then subjected to a thermal annealing process 170 to form covalent bonds at dielectric-to-dielectric bonding interface of dies 135 to the second wafer 130 (this will also allow for Cu to Cu joint formation due to Cu creep at the anneal temperature). In some examples, the thermal annealing process 170 includes subjecting the combined semiconductor dies 135 and second wafer 130 to a temperature between 200C - 450°C. The resulting component includes the semiconductor dies 135 fully bonded to the second wafer 130.

As discussed above, in the illustrated example of FIG. 1, it is assumed that the first (source) wafer 130 is an original semiconductor wafer on which the semiconductor dies 135 were fabricated. However, in other examples, the source wafer 130 may be a reconstituted wafer that includes semiconductor dies fabricated on one or more other wafers and then transferred to the reconstituted wafer.

FIG. 2 shows an example die-to-wafer bonding process flow 200 that involves the reconstitution of the component chips to be bonded from their respective source wafers to an intermediate reconstituted wafer. This proposed process flow will enable pick and place and subsequent capillary force driven self assembly based hybrid bonding of multiple chiplets of different types, sizes, fabrication nodes simultaneously in batches containing multiple chiplets. In the illustrated example, the second wafer 130 (e.g., a semiconductor wafer) includes dies (e.g., semiconductor dies 135) cut from different wafers (e.g., more than one first wafer 120). One such example, as illustrated in FIG. 2, shows the semiconductor dies 135 (e.g., first dies), second dies 210, third dies 220, and fourth dies 230 associated with four separate wafers.

At a first die placement stage 240 (e.g., a wafer reconstitution stage, a first pick-and-place operation) of FIG. 2, a pick-and-place assembly 250 collects/picks up the first dies 135, second dies 210, third dies 220, and fourth dies 230 and moves them to a carrier 260. The carrier 260 may correspond to a semiconductor wafer and/or any other suitable material that can serve as the underlying substrate for a reconstituted wafer. The carrier 260 supports the dies 135, 210, 220, 230 in a desired spatial relationship or layout for subsequent transfer to the second (final target) wafer 130. Thus, the carrier 260 initially functions as a "target wafer" to which the dies 135, 210, 220, 230 are transferred from corresponding "source wafers" (shown at left in FIG. 2), and then the carrier 260 (as a reconstituted wafer) becomes the "source wafer" for a second pick-and-place stage 270 (e.g., a second pick-and-place operation). In examples disclosed herein, the dies placed on the second wafer 130 can include any combination of dies and need not contain only dies from a single wafer (e.g., the semiconductor dies 135). As such, the example reconstitution process associated with the first die placement stage 240 of FIG. 2 is to enable the arrangement of multiple different dies from different wafers in a desired layout for subsequent bulk (batch) transfer to a final target wafer (e.g., the second wafer 130).

Transferring the dies 135, 210, 220, 230 to the carrier 260 to generate a reconstituted wafer may appear to increase production time by introducing intermediate operations of moving the dies 135, 210, 220, 230 from their original source wafers. However, this process can be performed relatively quickly because the alignment of the dies 135, 210, 220, 230 being reconstituted on the carrier 260 does not need to be very precise based on the fact that the dies 135, 210, 220, 230 will be moved again and to the final target wafer 130 and temporary misalignments will be resolved through the die-to-wafer self-aligning and bonding process 100 disclosed herein. Furthermore, by reconstituting the dies 135, 210, 220, 230 on to the carrier wafer 260, the process of moving the dies 135, 210, 220, 230 to the final target wafer 130 can be performed much more quickly because the pick-and-place assembly 250 can pick up and move multiple dies (e.g., a batch of dies) simultaneous that are already in proper arrangement relative to one another (based on the reconstitution of the dies 135, 210, 220, 230 on the carrier 260). At the first die placement stage 240, the water droplets 160 are not necessarily needed since the carrier 260 represents a temporary stage of the manufacturing process.

In some examples, once the reconstituted wafer (e.g., the carrier 260 filled with dies 135, 210, 220, 230) is created, the reconstituted wafer is taken through the first preparation process 110 as disclosed in connection with FIG. 1. In some examples, subjecting the reconstituted wafer to the first preparation process 110 has the advantage of performing the CMP process on the entire reconstituted wafer to ensure a clean and consistently smooth surface for improved hybrid bonding to the second wafer 130 after the second preparation stage 115.

At a second die placement stage 270, the pick-and-place assembly 250 positions the picks up the dies 135, 210, 220, 230 to place on the second wafer 130. In some examples, as represented in FIG. 2, this pick-and-place operation involves picking up multiple different ones of the dies 135, 210, 220, 230 at a single point in time (e.g., simultaneously) to then be transferred as a group, set, or batch on the second wafer 130. In some examples, the placement and subsequent bonding of the dies 135, 210, 220, 230 to the second wafer 130 follows the process set forth above in connection with FIG. 1. Thus, as illustrated in FIG. 2, a first batch 275 of the dies 135, 210, 220, 230 have already been transferred to the second wafer 130 and self-aligned through the capillary forces acting on the dies 135, 210, 220, 230.

Further, the pick-and-place assembly 250 is already holding a second batch 280 of the dies 135, 210, 220, 230 to be placed on the water droplets 160 that have already been dispensed onto the second wafer 130 for the second batch 280 of dies 135, 210, 220, 230. It should be understood the arrangement in which the dies 135, 210, 220, 230 are picked and placed by the pick-and-place assembly 250 is application-dependent. That is, the number, type, size, shape, and/or layout of the batch of dies picked up at a single time can differ for different applications. Thus, picking and placing such batches of dies of different dimensions reduces the time taken to transfer the dies to the second wafer 130 in combination with the reduction in precision placement of the dies because of the self-alignment of the dies. As plasma activation effect will reduce over time, the time saved at step 130 with picking and placing batches of dies can be beneficial, especially with very smaller die size (< 3x3 mm) which requires huge amount of time picking and placing one by one in some applications.

Examples disclosed herein are capable of picking and placing any suitable arrangement of dies (or any suitable number, type, size, shape, and/or layout) without a redesign or reconfiguration of the pick-and-place assembly 250. Thus, examples disclosed herein provide a universal semiconductor die pick and placement process irrespective of the arrangement of dies involved.

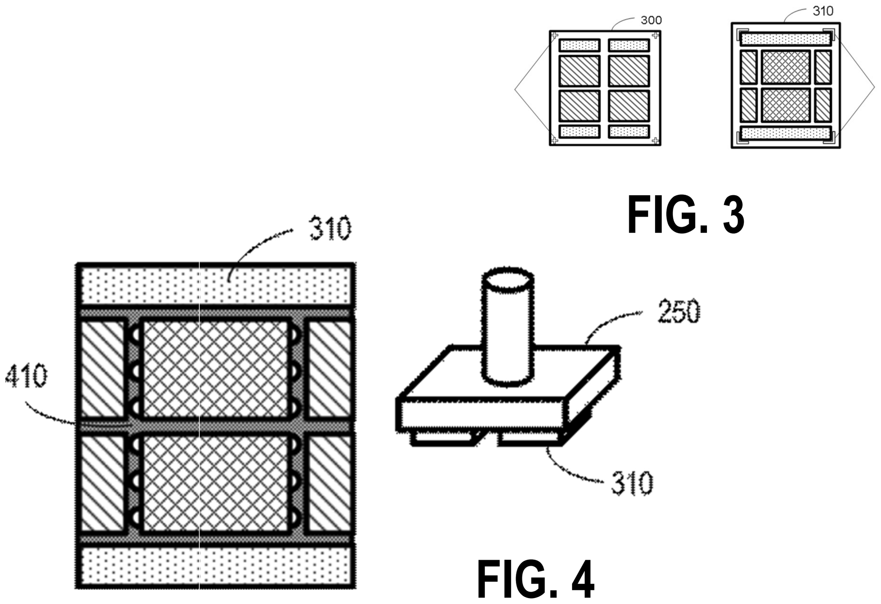

FIG. 3 shows example die arrangements for placement on a wafer (e.g., the second wafer 130). The example illustration of FIG. 3 shows a first die arrangement 300 and a second die arrangement 310. The first die arrangement 300 includes dies of differing shapes and sizes. The second die arrangement 310 includes a different set of dies of differing shapes and sizes compared to each other and relative to the first die arrangement 300. The example of FIG. 3 is purely to show that different die sizes, orientations, and/or configurations may be used to place on the second wafer 130. As such, while examples herein refer to using the first and second die arrangements 300, 310, any other arrangement may be used herein in which the dies are of different amounts, types, sizes, shapes, orientations, and/or layouts.

In some examples, the die arrangements 300, 310 correspond to a unit cell that is repeated across the wafer. The dies included in this unit cell may all be processed at a single point in time. Also shown in FIG. 3 are unit cell level fiducials and die array corner fiducials. In some examples, the unit cell level fiducials are provided on the bottom (target) wafer 130 to define markers that guide the alignment of the die arrangements 300, 310 when being transferred from a source wafer (e.g., a reconstituted wafer). In other examples, die array corner fiducials are provided on the die arrangements 300, 310 themselves to assist in alignment and placement of the die arrangements 300, 310 on the bottom wafer 130. The fiducials define a boundary of the die arrangements 300, 310. Different die arrangements may thus change the fiducials to define those boundaries.

FIG. 4 is an illustration of the example pick-and-place assembly 250 picking the die arrangement 310 of FIG. 3. While the example illustration of FIG. 4 shows the pick-and-place assembly 250 picking up only one of the die arrangements described in FIG. 3, it should be understood that any die arrangement can be interchangeably used herein to be picked up by the pick-and-place assembly 250. The die arrangement 310 is lifted (or grabbed) to the non contact head 410 via the force applied by the pick-non-contact nozzle assembly 250 so that the die arrangement 310 can be picked up and placed on the second wafer 130. The non-contact head 410 corresponds in size (e.g., covers the boundary) defined by the fiducials 320, 330 of FIG. 3. Thus, the nozzle head 410 may be sized so as to pick up the die arrangements defined by the fiducials 320, 330.

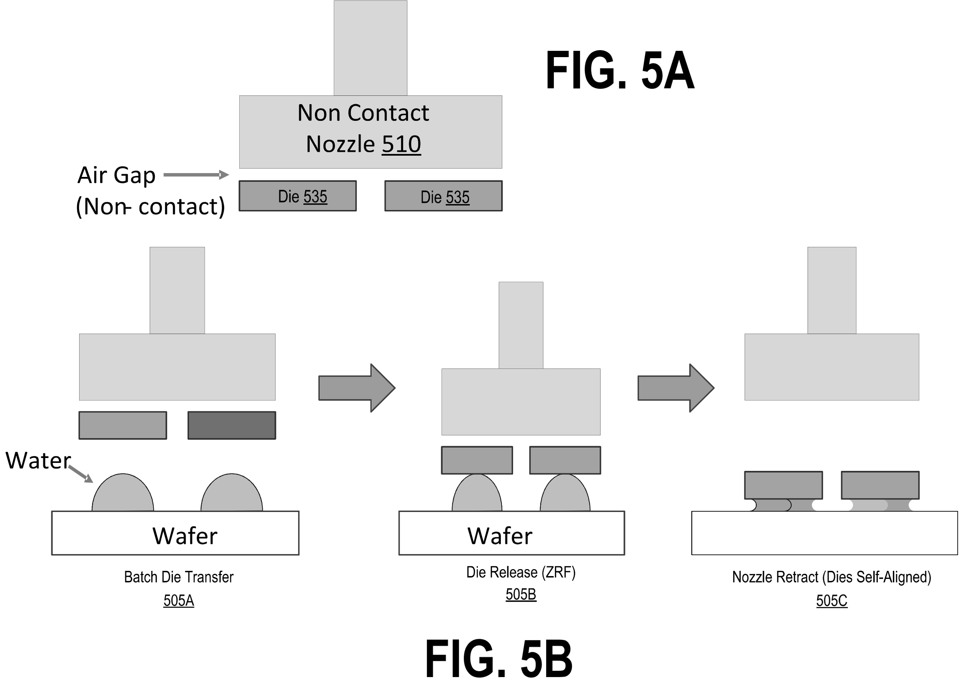

FIG. 5A is an example pick-and-place assembly for picking up the example die arrangements 300, 310 of FIG. 3. In some examples, the pick-and-place assembly includes a non contact nozzle head 510 for picking up the dies 135, 210, 220, 230. In some examples, the nozzle head has suitable non contact levitation head (examples discussed below) to lift the dies 135, 210, 220, 230 close to the head 510 for picking and placing on the second wafer 130. The pick-and-place assembly 250 is described in further detail herein.

FIG. 5B illustrates a pick-and-place assembly 250 implementing means for positioning a plurality of dies on the water droplets on a semiconductor wafer. At 505A, the dies are placed. At 505B, the nozzle releases the dies, and at 505C, the nozzle is retracted, with the dies self-aligning via the capillary action from the water droplets.

FIG. 6 is an example wafer 600 including the die arrangements 300, 310 of FIG. 3. In examples disclosed herein, the wafer 600 (also referred to as the second wafer 130 of FIG. 1) includes a plurality of dies bonded to the surface of the wafer 600. As mentioned above, dies can be of different sizes, orientations, shapes, etc., and the pick-and-place assembly 250 can pick up and place multiple arrangements of dies.

The number of individual dies that can be placed on the wafer 600 is dependent on a size of the wafer 600. As illustrated in FIG. 6, the wafer 600 includes one instance of the second die arrangement 310 of FIG. 3 having been placed on the wafer 600. The wafer 600 includes hydrophobic regions 610 and hydrophilic regions 620, the hydrophilic regions 620 representing where additional dies are to be placed. As described above, in some examples, the pick-and-place assembly 250 transfers all of the dies in the second die arrangement 310 simultaneously. In some such examples, the pick-and-place assembly 250 repeats the process to transfer additional instances of the second die arrangement 310 to the wafer 600 onto corresponding reticles of the hydrophilic regions 620 In some examples, the hydrophobic regions 610 and the hydrophilic regions 620 are activated (e.g., the adhesion properties of the surface of the wafer 600 are enhanced) during a plasma activation of the surface of the wafer 600 (e.g., the second plasma activation 150 of FIG. 1). The hydrophobic regions 610 repel water/fluid and the hydrophilic regions 620 attract water/fluid.

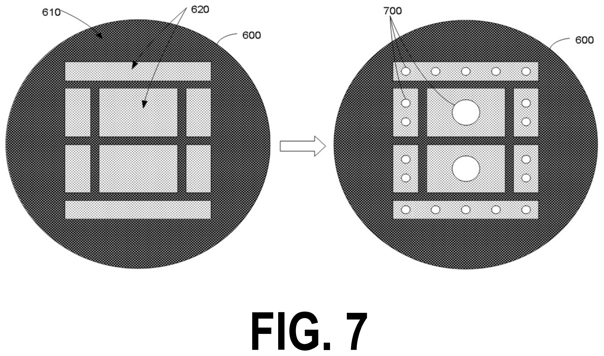

FIG. 7 shows the example wafer 600 of FIG. 6 before and after the application of water to facilitate the self-alignment of the example dies 135, 210, 220, 230 of FIG. 2 on the example wafer 600. As shown in FIG. 7, water droplets 700 are placed on the hydrophilic regions 620. In some examples, the hydrophilic regions 620 are different sizes, corresponding to different sized dies to be bonded to the wafer 600. In some examples, the size of each water droplet 700 and the amount of water droplets on each hydrophilic region 620 is tailored to the size of the die so that the water will cover the entire area of the hydrophilic regions 620 once the dies 135, 210, 220, 230 are placed on top. In some such examples, larger dies, with a corresponding larger hydrophilic region, are placed on a larger water droplet 700. In other such examples, dies of unique shapes (e.g., rectangular, triangular, etc.) are placed on multiple smaller water droplets.

As mentioned above, once the dies 135, 210, 220, 230 are placed on the water droplets 700, the water spreads out over the entire hydrophilic region 620, creating a bonding boundary to alignment the entire dies 135, 210, 220, 230 to the wafer 600. Due to the inclusion of the hydrophobic regions 610 surrounding the hydrophilic regions 620, the water will spread up to the edge of the hydrophilic regions 620 without extending beyond this edge into the hydrophobic regions 610. This allows for less accuracy required in dispensing the water droplets 700 but still maintains precision control for which to self-align the dies 135, 210, 220, 230. This precise control with which the water spreads out enables the self-alignment of the dies 135, 210, 220, 230 by causing (through capillary forces) the dies 135, 210, 220, 230 to shift into alignment with the edge of the spread out water. By causing the dies 135, 210, 220, 230 to align with the edge of the spread out water (which is controlled by the edge of the hydrophilic regions 620), the dies 135, 210, 220, 230 will become aligned with the hydrophilic regions 620. Therefore, less accuracy is required to place the dies 135, 210, 220, 230 on the wafer 600 since the dies 135, 210, 220, 230 self-align using the water, the hydrophobic regions 610, and the hydrophilic regions 620. In some examples, the alignment accuracy achieved by this self-aligning process can be less than 200 nm.

In some examples, the water droplets 700 are dispensed hydrophilic regions 620 of FIG. 6 at different points in time. In some examples, at a first point in time, first amounts of the water droplets 700 are dispensed on first hydrophilic regions corresponding to a first area of the hydrophilic regions 620 covered by the fiducials 320, 330. In some examples, at a second point in time different than the first point in time, second amounts of the water droplets 700 are dispensed on second hydrophilic regions corresponding to a second area of the hydrophilic regions 620. In such an example, the second area may include a different arrangement of the fiducials 320, 330 corresponding to a different die arrangement than the first area without the need to change the vacuum head 410. In some examples, a first batch of dies (e.g., a first arrangement of the dies 135, 210, 220, 230) are simultaneously positioned on the first amounts of water. In some examples, a second batch of dies (e.g., a second arrangement of the dies 135, 210, 220, 230) are simultaneously positioned on the second amounts of water.

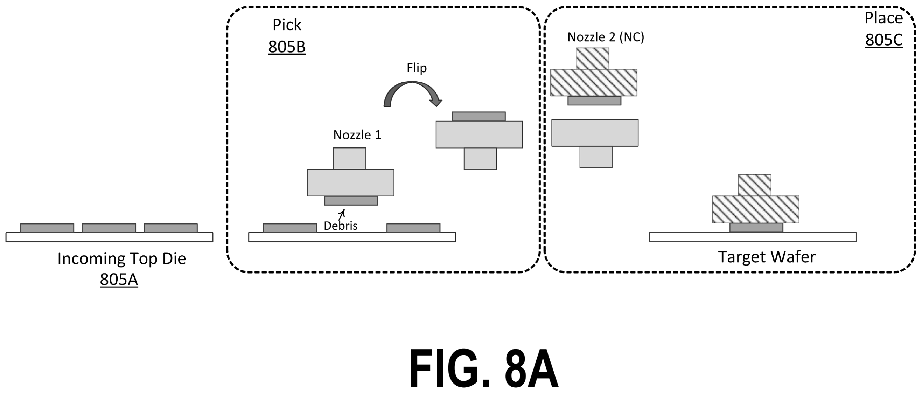

FIG. 8A illustrates how a die may be transferred using a non-contact nozzle in accordance with some embodiments. Initially, at 805A, dies to be places are disposed atop a source wafer or carrier (film, tape, etc.) At 805B, a first nozzle (nozzle 1), which may be any suitable nozzle including a contacting vacuum nozzle, grabs a die, with its contacts on its top side, and rotates vertically so that its contacts are now on its under side. The figure shows where debris e.g., from adhesives, etc.) may be located on its top side surface that will be grabbed by the nozzle. This illustrates how using a non contact nozzle can be beneficial in that it does not require cleaning, at least as often as contacting nozzle heads, since it does not come into contact with the dirty die surface. At 805C, the second nizzle, which is a non contact nozzle, grabs the die from the first nozzle and then places it onto the target wafer.

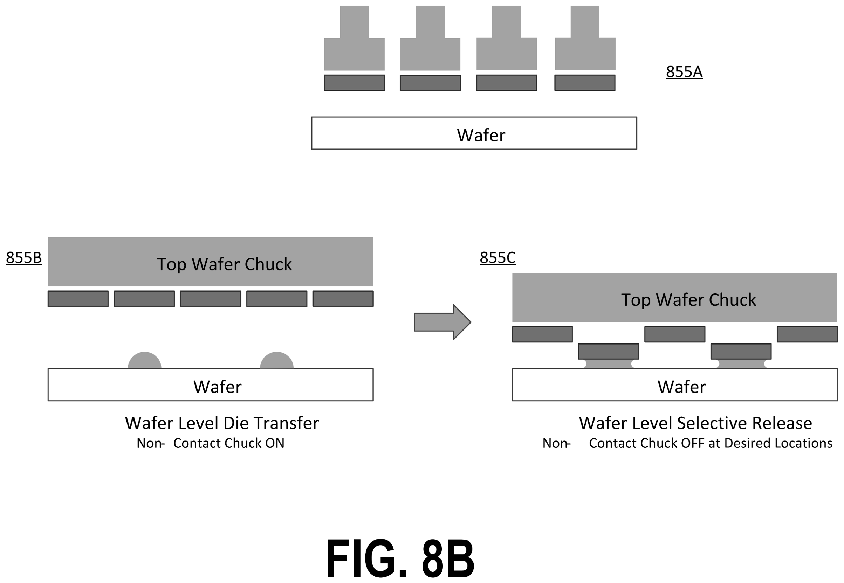

FIG. 8B is a diagram illustrating how batch pick and place can be implemented with non contact nozzles in accordance with some embodiments. To further increase the throughput of the batch pick and place, the batch pick and place non contact nozzles can be expanded, e.g., up to 300 mM wafer level chuck. The chuck has the same non-contact feature for die handling. At wafer level die pick and place, each individual die with non-contact mechanism can be switched on/off independently. Therefore, with these mechanisms, the dies on the wafer level non-contact chuck can be released onto the target wafer selectively as shown in the figure. The dies that need to be released each cycle can be programmed as recipe settings based on the product design. A similar transfer can be achieved by array of non-contact nozzles that can tolerate different die-to-die spacing and die sizes with individually controlled degrees of freedom (X, Y, Z and theta). The entire array of nozzles can be used for either die transfer at the same time or selectively.

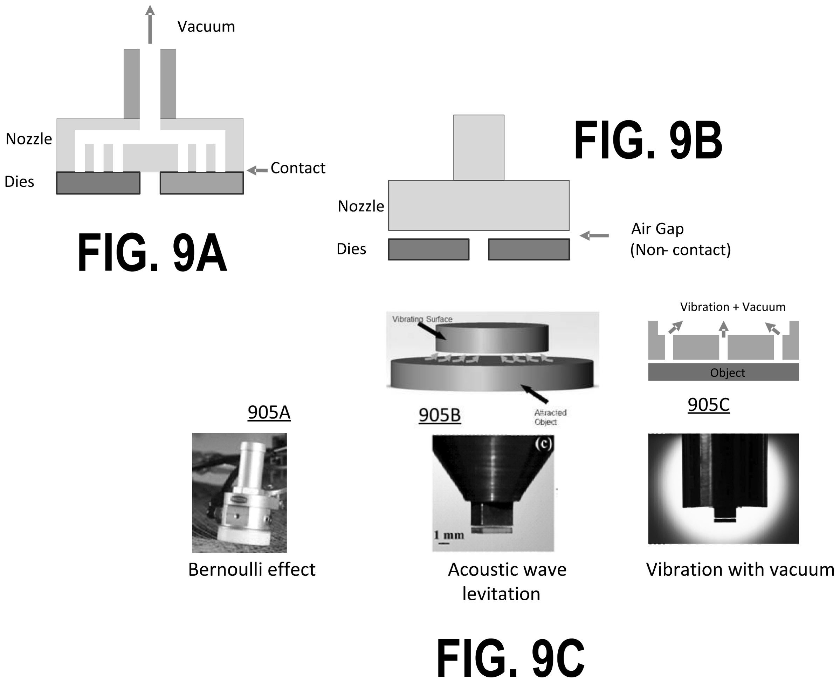

Figs. 9A-9C are diagrams contrasting contact and non-contact nozzles and providing examples of non contact nozzles in accordance with some embodiments. The nozzle of FIG. 9A is a vacuum nozzle with a nozzle head that makes contact with a die. In contrast, the nozzle of FIG. 9B is able to levitate dies very close to its nozzle head surface but without making contact. FIG. 9C shows a variety of different non-contact nozzle types. At 905, a non contact nozzle using a Bernoulli effect is shown. At 905B, a non contact nozzle using acoustic wave levitation is shown. At 905C, a non contact nozzle using finely tuned vacuum forces from vibrational actuation is shown. Depending on specific design needs, any of these, or other, non contact solutions may be appropriate.

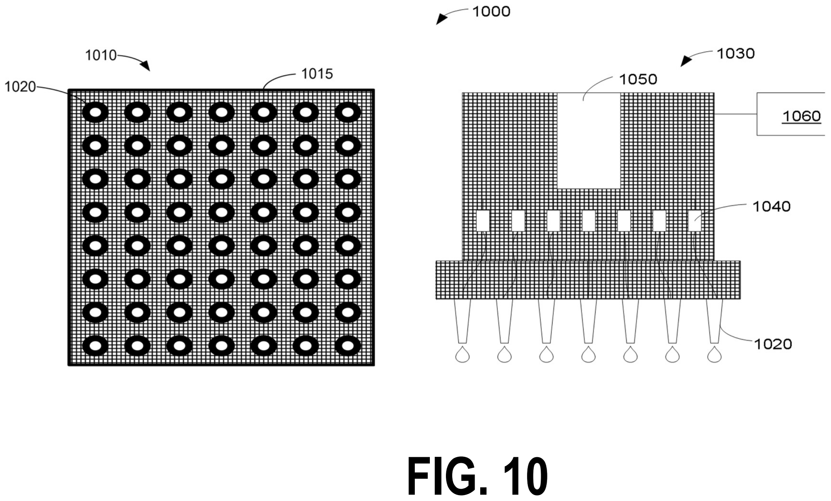

FIG. 10 is an example fluid dispensing assembly 1000 to dispense water on the example wafer 600 of FIG. 6. That is, the example fluid dispensing assembly 1000 enables and/or controls the dispensing of the water droplets 700 discussed above in connection with FIG. 7. A bottom view 1010 shows a nozzle head 1015 of the fluid dispensing assembly 1000. In this example, the nozzle head 1015 includes a two-dimensional array of nozzles 1020 spaced across the nozzle head 1015 for dispensing water/fluid onto the wafer 600. In some examples, the spacing of the nozzles 1020 is uniform (e.g., spaced evenly). In other examples, the spacing of the nozzles 1020 is non-uniform. Regardless of the particular size, number, and/or spacing of the nozzles 1020, in some examples, the nozzles 1020 are arranged to be sufficiently small and sufficiently close together to enable the application of water/fluid droplets to any suitable arrangement of hydrophilic regions within a single reticle.

A side/cross-sectional view 1030 shows the nozzles 1020 for dispensing water/fluid onto the wafer 600, a plurality of valves 1040, a fluid source 1050, and fluid dispenser controller circuitry 1060.

The plurality of valves 1040 dispense water/fluid from the fluid source 1050 onto the wafer 600. In some examples, each valve 1040 can be controlled independently and is operably connected to the nozzles 1020. In some examples, the fluid source 1050 contains a static supply (e.g., a reservoir holding a pre-defined amount of fluid). In other examples, the fluid source 1050 contains a continuous supply of fluid (e.g., the fluid source 150 has a continuous supply of fluid). In some examples, the fluid source 1050 is a water source. In the illustrated example, the fluid source 1050 is shown as being part of the fluid dispensing assembly 1000. However, in other examples, the fluid source 1050 is separate from but fluidly coupled to the fluid dispensing assembly 1000. In some examples, the valves 1040 allow the water/fluid to flow through the valves 1040 and into the nozzles 1020 where the water/fluid is then dispensed onto the wafer 600. In some examples, the fluid dispensing assembly 1000 implements means for dispensing water on a semiconductor wafer.

The fluid dispenser controller circuitry 1060 controls the valves 1040. In some examples, the fluid dispenser controller circuitry 1060 independently controls the valves 1040 to regulate the amount of water/fluid dispensed through the nozzles 1020. In some examples, the valves 1040 are on/off valves that either block or permit fluid to be dispensed through the nozzles 1020 such that the amount of water/fluid through a given valve 1040 is controlled by how long the valve 1040 is opened. In other examples, the valves 1040 can control the flow rate of fluid through ones of the nozzles 1020 such that the amount of water/fluid is based on both how long the valve 1040 is opened and the flow rate permitted by the open valve. In some examples, where one individual nozzle 1020 may be positioned over larger hydrophilic regions 620 (e.g., corresponding to a larger die size), a larger volume of water can be dispensed through the nozzle 1020. Likewise, with smaller hydrophilic regions 620, a smaller volume of water can be dispensed through the nozzle 1020 through the independent control of the valves 1040. In other examples, a substantially consistent amount of water is dispensed through different ones of the nozzles 1020. In such examples, different amounts of water are applied to different sizes of hydrophilic regions 620 due to the number of nozzles 1020 aligned with each hydrophilic region 620. Additionally or alternatively, in some examples, at least some of the valves 1040 align with smaller hydrophilic regions 620 will remain closed to reduce the amount of water dispensed to those regions relative to larger hydrophilic regions 620. In some examples, the fluid dispenser controller circuitry 1060 implements means for regulating an amount of water/fluid to be dispensed through each nozzle 1020 of the fluid dispensing assembly 1000.

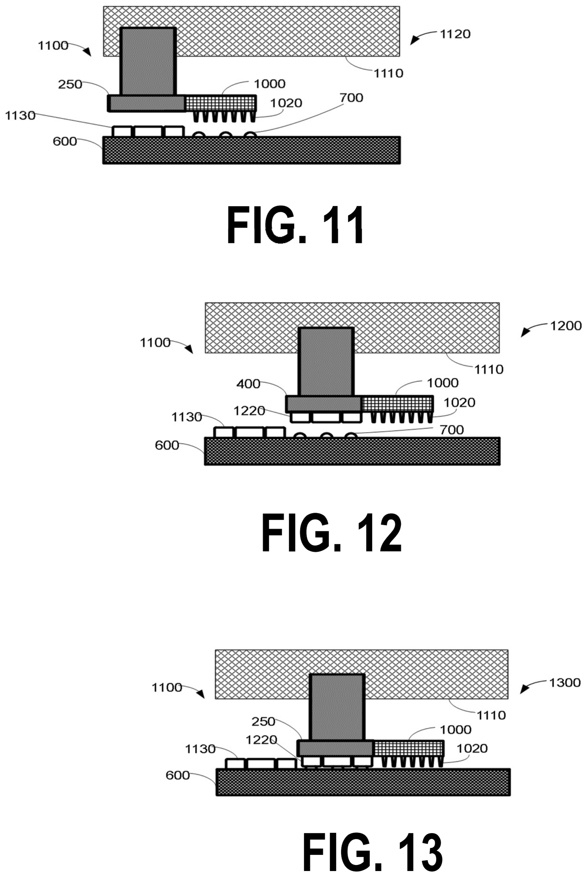

FIGS. 11-13 illustrate a first example bonding machine 1100 for dispensing fluid and picking and placing the dies of FIG. 3. The first example bonding machine 1100 includes the example fluid dispensing assembly 1000 of FIG. 10 and the example pick-and-place assembly 250 of FIG. 2 with one or more non contact nozzles. In this example, the fluid dispensing assembly 1000 and the pick-and-place assembly 250 fixedly coupled/joined together to operate and/or move as a unit. In some examples, the collective movement of both the fluid dispensing assembly 1000 and the pick-and-place assembly 250 is implemented by a first gantry 1110. In some examples, the first gantry 1110 includes robotic arms, hydraulic actuators, etc., to move the first example bonding machine 1100 to place the dies 135, 210, 220, 230 and dispense the water (e.g., the water droplets 700 of FIG. 7). In the illustrated example of FIGS. 11-13, the fluid dispensing assembly 1000 and the pick-and-place assembly 250 move as one and can perform their respective actions (e.g., dispense fluid and pick up/position dies respectively) in parallel (e.g., simultaneously). That is, while the pick-and-place assembly 250 is placing a first batch of dies onto the semiconductor wafer 600, the fluid dispensing assembly 1000 dispenses water droplets on an adjacent area to prepare that area to receive a second batch of dies.

FIG. 11 shows the first example bonding machine 1100 in a first position 1120. The first position 1120 shows the pick-and-place assembly 250 just after having placed a first batch of dies 1130 (e.g., the dies 135, 210, 220, 230) and the fluid dispensing assembly 1000 just after having dispensed the water droplets 700 on the wafer 600 adjacent the first batch of dies 1130 in preparation for a second batch of dies. As disclosed herein, the pick-and-place assembly 250 can pick up any arrangement of dies, and thus the dies 135, 210, 220, 230 can be in any order or arrangement when picked up by the pick-and-place assembly 250. Similarly, in this example, the fluid dispensing assembly 1000 can dispense water droplets onto any arrangement of hydrophilic regions on the semiconductor wafer 600 corresponding to the arrangement of dies carried by the pick-and-place assembly 250. Thus, in this example, the non-contact head of the pick-and-place assembly 250 and the nozzle head 1015 of the fluid dispensing assembly 1000 are approximately the same size and/or cover approximately the same area (e.g., corresponding to a reticle of the semiconductor wafer 600).

FIG. 12 shows the first example bonding machine 1100 in a second position 1200. The second position 1200 shows the pick-and-place assembly 250 having picked up a second batch of dies 1220 and moved to position the second batch of dies 1220 to be above the water droplets 700 dispensed by the fluid dispensing assembly 1000 just after the bonding machine 1100 was in the first position 1120 represented in FIG. 11. Inasmuch as the pick-and-place assembly 250 and the fluid dispensing assembly 1000 are affixed to move as a unit, by positioning the second batch of dies 1220 above the water droplets 700, the fluid dispensing assembly 1000 is shifted to be above a next adjacent area of the semiconductor wafer 600.

FIG. 13 shows the first example bonding machine 1100 in a third position 1300. The third position 1300 shows the pick-and-place assembly 250 placing the second batch of dies 1220 (e.g., a second instance of the dies 135, 210, 220, 230) on the wafer 600. Also, in the third position 1300, the fluid dispensing assembly 1000 may dispense water droplets 700 on the next set of hydrophilic regions 620 for placing subsequent batches of dies (e.g., subsequent instances of the dies 135, 210, 220, 230). Thus, as shown in FIG. 13, the pick-and-place assembly 250 and the fluid dispensing assembly 1000 are operating in parallel to place the dies on the water droplets 700 and to dispense additional water droplets 700 for subsequent batches of dies to be positioned.

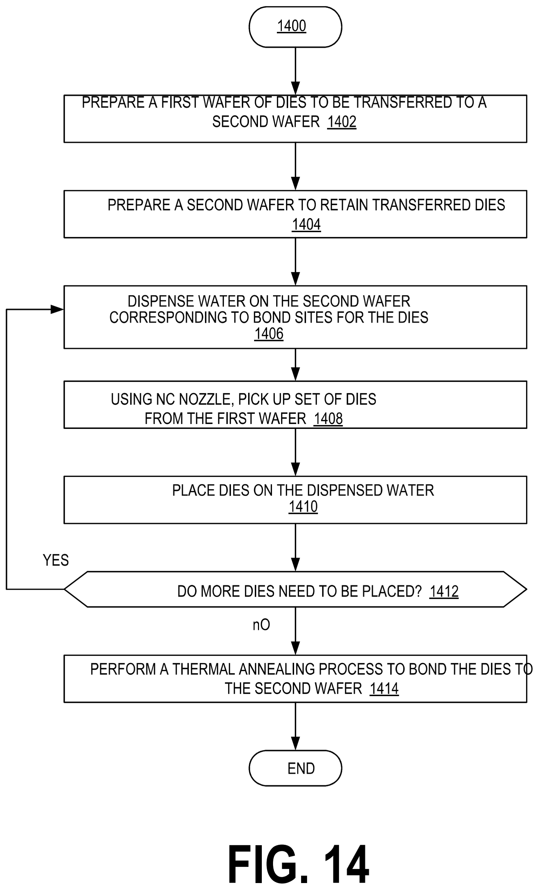

FIG. 14 is a flowchart representative of example methods of operating the example bonding machines 1100, 1400 to implement the example die-to-wafer self-aligning and bonding process 100 of FIG. 1. While the flowchart represents example operations that can be used to implement the example die-to-wafer self-aligning and bonding process 100, the operations can be implemented by machine readable instructions which may be executed or instantiated by programmable circuitry.

FIG. 14 is a flowchart representative of example machine readable instructions and/or example operations 1400 that may be performed through a manufacturing process and/or executed, instantiated, and/or performed by programmable circuitry to perform the semiconductor die to wafer self-aligning and bonding process 100 of FIG. 1. The example machine-readable instructions and/or the example operations 1400 of FIG. 17 begin at block 1402, at which a first wafer (e.g., the top wafer 120 in FIG. 1) of dies (e.g., the dies 135, 210, 220, 230) is prepared to be transferred to a second wafer (e.g., the bottom wafer 130). In some examples, the dies 135, 210, 220, 230 come from cutting a single wafer. In other examples, the dies 135, 210, 220, 230 come from cutting/combining dies from multiple wafers into a reconstituted wafer (e.g., see FIG. 2).

Once the first wafer of dies is prepared, the second wafer is prepared to retain the transferred dies. (Block 1404). In some examples, preparing the second wafer includes subjecting the second wafer to a plasma activation process and a cleaning. In examples disclosed herein, the second wafer is subjected to a plasma activation process (e.g., the second plasma activation 150) to activate hydrophobic and hydrophilic regions (e.g., the hydrophobic regions 610 and the hydrophilic regions 620) on the second wafer. (Block 1406). In some examples, the hydrophilic regions are activated to make the adhesive properties of the second wafer greater. In some examples, the hydrophobic regions are activated to ensure that water, once placed on the second wafer, does not escape the bonding sites (e.g., where the dies 135, 210, 220, 230 are to be bonded to the second wafer) and ensure that the dies 135, 210, 220, 230 self-align through capillary forces from the water. In examples disclosed herein, the second wafer is subjected to a cleaning (e.g., the second cleaning 155) to ensure that no debris or foreign bodies/objects are left on the surface of the second wafer that could interfere with the bonding of the dies 135, 210, 220, 230 to the second wafer.

Once the second wafer has been prepared, the fluid dispenser controller circuitry 1060 dispenses water on the second wafer corresponding to bond sites for the dies 135, 210, 220, 230. (Block 1406). In examples disclosed herein, the water is dispensed on the second wafer by the fluid dispensing assembly 1000. In some examples, the fluid dispenser controller circuitry 1060 determines a proper amount of water to be dispensed based on the size and/or orientation of the dies 135, 210, 220, 230.

Once the water has been dispensed by the fluid dispensing assembly 1000 (as controlled by the fluid dispenser controller circuitry 1060) on the second wafer, the pick-and-place-assembly 250 picks up a set (e.g., batch) of the dies 135, 210, 220, 230. (Block 1408). In some examples, the set or batch of dies corresponds to all dies corresponding to a particular reticle of the second wafer. In some examples, the dies 135, 210, 220, 230 picked up include dies cut from multiple different wafers (e.g., see FIG. 2).

Once the dies 135, 210, 220, 230 have been picked up, the pick-and-place-assembly 250 places the dies 135, 210, 220, 230 on the dispensed water. (Block 1410). In examples disclosed herein, the accuracy required of the pick-and-place-assembly 250 to place the dies 135, 210, 220, 230 on the water is relatively low due to the capillary forces acting on the dies 135, 210, 220, 230 once placed to self-align the dies 135, 210, 220, 230 on the hydrophilic regions of the second wafer. Moreover, with the use of non-contact nozzles, which allow for zero force release, the water droplets may be tuned substantially for die alignment.

Once the dies 135, 210, 220, 230 have been placed, a determination is made as to whether more dies need to be placed. (Block 1412). When it is determined that more dies need to be placed (e.g., block 1412 returns a result of YES), blocks 1406 through 1410 are repeated until all dies have been placed. As discussed above, in some examples, water is dispensed (at block 106) for a next set or batch of dies in parallel with (e.g., simultaneously with) the placement of a previous set or batch of dies.

Once all dies have been placed and a determination is made that no additional dies are to be placed (e.g., block 1412 returns a result of NO), then a thermal annealing process (e.g., the thermal annealing process 170) is performed on the second wafer with all dies having been placed on the second wafer. (Block 1414). In the examples disclosed herein, the thermal annealing process, in conjunction with the presence of the water, causes the formation of covalent bonds between the dies 135, 210, 220, 230 and the second wafer.

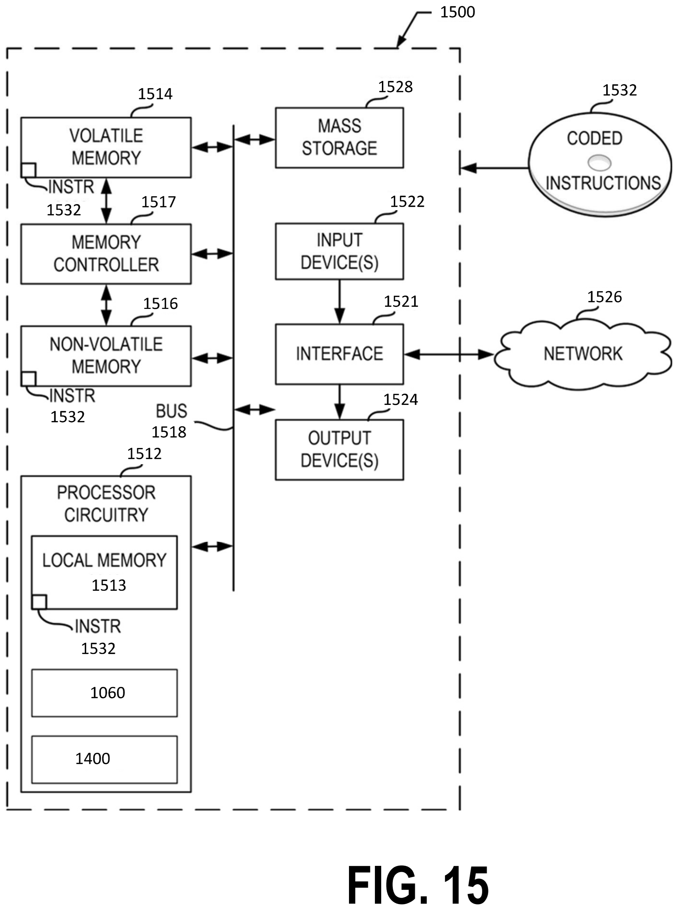

FIG. 15 is a block diagram of an example programmable circuitry platform 1500 structured to execute and/or instantiate the example machine-readable instructions and/or the example operations of FIG. 14 to implement the example semiconductor die to wafer self-aligning and bonding process 100 of FIG. 1. The programmable circuitry platform 1500 can be, for example, a server, a personal computer, a workstation, a self-learning machine (e.g., a neural network), a mobile device (e.g., a cell phone, a smart phone, a tablet such as an iPadTM), or any other type of computing and/or electronic device.

The programmable circuitry platform 1500 of the illustrated example includes programmable circuitry 1512. The programmable circuitry 1512 of the illustrated example is hardware. For example, the programmable circuitry 1512 can be implemented by one or more integrated circuits, logic circuits, FPGAs, microprocessors, CPUs, GPUs, DSPs, and/or microcontrollers from any desired family or manufacturer. The programmable circuitry 1512 may be implemented by one or more semiconductor based (e.g., silicon based) devices. In this example, the programmable circuitry 1512 implements the example semiconductor die to wafer self-aligning and bonding process 100 of FIG. 1 and fluid dispenser controller circuitry 1060.

The programmable circuitry 1512 of the illustrated example includes a local memory 1513 (e.g., a cache, registers, etc.). The programmable circuitry 1512 of the illustrated example is in communication with main memory 1514, 1516, which includes a volatile memory 1514 and a non-volatile memory 1516, by a bus 1518. The volatile memory 1514 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 1516 may be implemented by flash memory and/or any other desired type of memory device. Access to the main memory 2014, 1516 of the illustrated example is controlled by a memory controller 1517. In some examples, the memory controller 1517 may be implemented by one or more integrated circuits, logic circuits, microcontrollers from any desired family or manufacturer, or any other type of circuitry to manage the flow of data going to and from the main memory 1514, 1516.

The programmable circuitry platform 1500 of the illustrated example also includes interface circuitry 1520. The interface circuitry 1520 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 1522 are connected to the interface circuitry 1520. The input device(s) 1522 permit(s) a user (e.g., a human user, a machine user, etc.) to enter data and/or commands into the programmable circuitry 1512. The input device(s) 1522 can be implemented by, for example, a keyboard, a button, a mouse, a touchscreen, a trackpad, a trackball, an isopoint device, and/or a voice recognition system.

One or more output devices 2024 are also connected to the interface circuitry 1520 of the illustrated example. The output device(s) 1524 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.). The interface circuitry 1520 of the illustrated example, thus, typically includes a graphics driver card, a graphics driver chip, and/or graphics processor circuitry such as a GPU.

The interface circuitry 1520 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 1526. The communication can be by, for example, an Ethernet connection, a digital subscriber line (DSL) connection, a telephone line connection, a coaxial cable system, a satellite system, a beyond-line-of-sight wireless system, a line-of-sight wireless system, a cellular telephone system, an optical connection, etc.

The programmable circuitry platform 1500 of the illustrated example also includes one or more mass storage discs or devices 1528 to store firmware, software, and/or data. Examples of such mass storage discs or devices 1528 include magnetic storage devices (e.g., floppy disk, drives, HDDs, etc.), optical storage devices (e.g., Blu-ray disks, CDs, DVDs, etc.), RAID systems, and/or solid-state storage discs or devices such as flash memory devices and/or SSDs.

The machine readable instructions 1532, which may be implemented by the machine readable instructions of FIG. 17, may be stored in the mass storage device 1528, in the volatile memory 1514, in the non-volatile memory 1516, and/or on at least one non-transitory computer readable storage medium such as a CD or DVD which may be removable.

### Examples

Illustrative examples of the technologies disclosed herein are provided below. An embodiment of the technologies may include any one or more, and any compatible combination of, the examples described below.

Example 1 is an apparatus that includes a fluid dispensing assembly. The fluid dispensing assembly is to: (i) dispense first amounts of water onto first hydrophilic regions of a first semiconductor wafer at a first point in time, the first hydrophilic regions having a first arrangement, and (ii)dispense second amounts of water onto second hydrophilic regions of a second semiconductor wafer at a second point in time different than the first point in time, the second hydrophilic regions having a second arrangement different than the first arrangement. The apparatus also includes a pick-and-place assembly to: (i) using at least one non-contact nozzle to position, at the first point in time, a first batch of dies onto the first amounts of water dispensed on the first semiconductor wafer, the first batch of dies corresponding to the first arrangement of the first hydrophilic regions; and (ii) using the at least one non-contact nozzle to position, at the second point in time, a second batch of dies onto the second amounts of water dispensed on the second semiconductor wafer, the second batch of dies corresponding to the second arrangement of the second hydrophilic regions.

Example 2 includes the subject matter of example 1, and wherein the first hydrophilic regions are surrounded by first hydrophobic regions, the first batch of dies to self-align when placed on the first semiconductor wafer using the first hydrophilic regions and the first hydrophobic regions on the first semiconductor wafer.

Example 3 includes the subject matter of any of examples 1-2, and wherein the first amounts of water are sufficient to spread across the first hydrophilic regions when the first batch of dies are positioned thereon, the first amounts of water to be retained by first hydrophobic regions surrounding the first hydrophilic regions.

Example 4 includes the subject matter of any of examples 1-3, and wherein the at least one non contact nozzle includes one or more of a Bernoulli effect nozzle, an acoustic wave levitation nozzle, and/or a vibrational actuation nozzle.

Example 5 includes the subject matter of any of examples 1-4, and wherein the at least one non contact nozzle includes a plurality of holes distributed across the non-contact head.

Example 6 includes the subject matter of any of examples 1-5, and wherein the one or more openings are dimensioned and spaced apart to pick up different arrangements of dies including the first arrangement and the second arrangement.

Example 7 includes the subject matter of any of examples 1-6, and wherein the one or more openings include: first elongate apertures extending in a first direction; and second elongate apertures traversing the first elongate apertures.

Example 8 includes the subject matter of any of examples 1-7, and wherein the fluid dispensing assembly includes: a nozzle head; and a plurality of dispensing nozzles distributed across the nozzle head of the fluid dispensing assembly to dispense the first amounts of water and the second amounts of water on the first and second semiconductor wafers.

Example 9 includes the subject matter of any of examples 1-8, and wherein the fluid dispensing assembly includes: a plurality of valves operably coupled to the plurality of dispensing nozzles to dispense the first amounts of water and the second amounts of water from a water source; and controller circuitry to control the plurality of valves, the plurality of valves to regulate flow of the first amounts of water and the second amounts of water through the plurality of dispensing nozzles.

Example 10 includes the subject matter of any of examples 1-9, and wherein the fluid dispensing assembly and the pick-and-place assembly are fixedly coupled to one another, the fluid dispensing assembly and the pick-and-place assembly to respectively dispense water and position dies in parallel.

Example 11 includes the subject matter of any of examples 1-10, and wherein the fluid dispensing assembly and the pick-and-place assembly move independently, the fluid dispensing assembly and the pick-and-place assembly to respectively dispense water and position dies independently.

Example 12 is a method that includes dispensing first amounts of water on respective ones of first hydrophilic regions of a first semiconductor wafer at a first point in time, the first hydrophilic regions having a first arrangement; and positioning, at the first point in time, using non-contact nozzles, a first set of dies on the first amounts of water on the first semiconductor wafer, the first set of dies dimensioned and spaced apart according to the first arrangement of the first hydrophilic regions; dispensing second amounts of water on respective ones of second hydrophilic regions of a second semiconductor wafer at a second point in time, the second hydrophilic regions having a second arrangement different than the first arrangement; and positioning, at the second point in time, using the non contact nozzles, a second set of dies on the second amounts of water on the second semiconductor wafer, the second set of dies dimensioned and spaced apart according to the second arrangement of the second hydrophilic regions.

Example 13 includes the subject matter of example 12, and further including self-aligning the first plurality of dies on the first semiconductor wafer using the first hydrophilic regions covered by the first amounts of water, the first hydrophilic regions surrounded by first hydrophobic regions on the first semiconductor wafer.

Example 14 includes the subject matter of any of examples 12-13, and wherein the first amounts of water are sufficient to spread across the respective ones of the first hydrophilic regions when the first set of dies are positioned thereon, the first amounts of water to be retained by first hydrophobic regions surrounding the respective ones of the first hydrophilic regions.

Example 15 includes the subject matter of any of examples 12-14, and further including performing a thermal annealing process to bond the first plurality of dies to the first semiconductor wafer.

Example 16 includes the subject matter of examples 12-15, and further including: cutting a third semiconductor wafer into a first plurality of dies; and cutting a fourth semiconductor wafer into a second plurality of dies, the first set of dies including a first die from the first plurality of dies and a second die from the second plurality of dies.

Example 17 includes the subject matter of any of examples 12-16, and wherein the dispensing of the first amounts of water includes: identifying a first area for a first one of the first hydrophilic regions; identifying a second area for a second one of the first hydrophilic regions; determining a first one of the first amounts of water based on the first area; determining a second one of the first amounts of water based on the second area; controlling a first valve to dispense the first one of the first amounts of water via a first nozzle; and controlling a second valve to dispense the second one of the first amounts of water via a second nozzle.

Example 18 is an apparatus comprising means for dispensing water to: dispense water onto first hydrophilic regions of a first semiconductor wafer at a first point in time, the first hydrophilic regions distributed across a first area; and dispense water onto second hydrophilic regions of a second semiconductor wafer at a second point in time different than the first point in time, the second hydrophilic regions distributed across a second area, the first and second areas having a same size and a same shape, at least one of a size, a shape, an orientation, or a placement of ones of the first hydrophilic regions within the first area to be different than at least one of a size, a shape, an orientation, or a placement of ones of the second hydrophilic regions within the second area; and means for positioning to: position a first plurality of dies on the first hydrophilic regions, the water on the first hydrophilic regions to facilitate alignment of the first plurality of dies to the first hydrophilic regions; and position a second plurality of dies on the second hydrophilic regions, the water on the second hydrophilic regions to facilitate alignment of the second plurality of dies to the second hydrophilic regions.

Example 19 includes the subject matter of example 18, and wherein the means for positioning and the means for dispensing operate in parallel.

Example 20 includes the subject matter of any of examples 18-19, and wherein the means for positioning and the means for dispensing operate in series.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

As defined herein, the term "processor" means at least one hardware circuit configured to carry out instructions contained in program code. The hardware circuit may be implemented with one or more integrated circuits. Examples of a processor include, but are not limited to, a central processing unit (CPU), an array processor, a vector processor, a digital signal processor (DSP), a field-programmable gate array (FPGA), a programmable logic array (PLA), an application specific integrated circuit (ASIC), programmable logic circuitry, a graphics processing unit (GPU), a controller, and so forth. It should be appreciated that a logical processor, on the other hand, is a processing abstraction associated with a core, for example when one or more SMT cores are being used such that multiple logical processors may be associated with a given core, for example, in the context of core thread assignment.

It should be appreciated that a processor or processor system may be implemented in various different manners. For example, it may be implemented on a single die, multiple dies (dielets, chiplets), one or more dies in a common package, or one or more dies in multiple packages. Along these lines, some of these blocks may be located separately on different dies or together on two or more different dies.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The meaning of "in" includes "in" and "on" unless expressly distinguished for a specific description.

The terms "substantially," "close," "approximately," "near," and "about," unless otherwise indicated, generally refer to being within +/-10% of a target value.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

As defined herein, the term "if" means "when" or "upon" or "in response to" or "responsive to," depending upon the context. Thus, the phrase "if it is determined" or "if [a stated condition or event] is detected" may be construed to mean "upon determining" or "in response to determining" or "upon detecting [the stated condition or event]" or "in response to detecting [the stated condition or event]" or "responsive to detecting [the stated condition or event]" depending on the context. As defined herein, the term "responsive to" means responding or reacting readily to an action or event. Thus, if a second action is performed "responsive to" a first action, there is a causal relationship between an occurrence of the first action and an occurrence of the second action. The term "responsive to" indicates the causal relationship.

While the flow diagrams in the figures show a particular order of operations performed by certain embodiments of the invention, it should be understood that such order is exemplary (e.g., alternative embodiments may perform the operations in a different order, combine certain operations, overlap certain operations, etc.).

While the invention has been described in terms of several embodiments, those skilled in the art will recognize that the invention is not limited to the embodiments described, can be practiced with modification and alteration within the spirit and scope of the appended claims. The description is thus to be regarded as illustrative instead of limiting.

## Claims

1. An apparatus comprising:
a fluid dispensing assembly to:
(i) dispense first amounts of water onto first hydrophilic regions of a first semiconductor wafer at a first point in time, the first hydrophilic regions having a first arrangement, and
(ii)dispense second amounts of water onto second hydrophilic regions of a second semiconductor wafer at a second point in time different than the first point in time, the second hydrophilic regions having a second arrangement different than the first arrangement; and
a pick-and-place assembly to:
(i) using at least one non-contact nozzle to position, at the first point in time, a first batch of dies onto the first amounts of water dispensed on the first semiconductor wafer, the first batch of dies corresponding to the first arrangement of the first hydrophilic regions; and
(ii) using the at least one non-contact nozzle to position, at the second point in time, a second batch of dies onto the second amounts of water dispensed on the second semiconductor wafer, the second batch of dies corresponding to the second arrangement of the second hydrophilic regions.

2. The apparatus of claim 1, wherein the first hydrophilic regions are surrounded by first hydrophobic regions, the first batch of dies to self-align when placed on the first semiconductor wafer using the first hydrophilic regions and the first hydrophobic regions on the first semiconductor wafer.

3. The apparatus of any of claims 1-2, wherein the first amounts of water are sufficient to spread across the first hydrophilic regions when the first batch of dies are positioned thereon, the first amounts of water to be retained by first hydrophobic regions surrounding the first hydrophilic regions.

4. The apparatus of any of claims 1-3, wherein the at least one non contact nozzle includes one or more of a Bernoulli effect nozzle, an acoustic wave levitation nozzle, and/or a vibrational actuation nozzle.

5. The apparatus of claim 4, wherein the at least one non contact nozzle includes a plurality of holes distributed across the non-contact head.

6. The apparatus of claim 5, wherein the one or more openings are dimensioned and spaced apart to pick up different arrangements of dies including the first arrangement and the second arrangement.

7. The apparatus of claim 5, wherein the one or more openings include:
first elongate apertures extending in a first direction; and
second elongate apertures traversing the first elongate apertures.

8. The apparatus of any of claims 1-7, wherein the fluid dispensing assembly includes:
a nozzle head; and
a plurality of dispensing nozzles distributed across the nozzle head of the fluid dispensing assembly to dispense the first amounts of water and the second amounts of water on the first and second semiconductor wafers.

9. The apparatus of claim 8, wherein the fluid dispensing assembly includes:
a plurality of valves operably coupled to the plurality of dispensing nozzles to dispense the first amounts of water and the second amounts of water from a water source; and
controller circuitry to control the plurality of valves, the plurality of valves to regulate flow of the first amounts of water and the second amounts of water through the plurality of dispensing nozzles.

10. The apparatus of any of claims 1-9, wherein the fluid dispensing assembly and the pick-and-place assembly are fixedly coupled to one another, the fluid dispensing assembly and the pick-and-place assembly to respectively dispense water and position dies in parallel.

11. The apparatus of any of claims 1-10, wherein the fluid dispensing assembly and the pick-and-place assembly move independently, the fluid dispensing assembly and the pick-and-place assembly to respectively dispense water and position dies independently.

12. A method comprising:
dispensing first amounts of water on respective ones of first hydrophilic regions of a first semiconductor wafer at a first point in time, the first hydrophilic regions having a first arrangement; and
positioning, at the first point in time, using non-contact nozzles, a first set of dies on the first amounts of water on the first semiconductor wafer, the first set of dies dimensioned and spaced apart according to the first arrangement of the first hydrophilic regions;
dispensing second amounts of water on respective ones of second hydrophilic regions of a second semiconductor wafer at a second point in time, the second hydrophilic regions having a second arrangement different than the first arrangement; and
positioning, at the second point in time, using the non contact nozzles, a second set of dies on the second amounts of water on the second semiconductor wafer, the second set of dies dimensioned and spaced apart according to the second arrangement of the second hydrophilic regions.

13. The method of claim 12, further including self-aligning the first plurality of dies on the first semiconductor wafer using the first hydrophilic regions covered by the first amounts of water, the first hydrophilic regions surrounded by first hydrophobic regions on the first semiconductor wafer.

14. The method of any of claims 12-13, wherein the first amounts of water are sufficient to spread across the respective ones of the first hydrophilic regions when the first set of dies are positioned thereon, the first amounts of water to be retained by first hydrophobic regions surrounding the respective ones of the first hydrophilic regions.

15. The method of any of claims 12-14, further including performing a thermal annealing process to bond the first plurality of dies to the first semiconductor wafer.
